# EUROPÄISCHE PATENTANMELDUNG

(11) **EP 4 686 324 A1**
(43) Veröffentlichungstag der Anmeldung: **28.01.2026**
(21) Anmeldenummer: 24191044.7
(22) Anmeldetag: 26.07.2024
(51) Int. Cl.: H05K 1/02, H05K 7/20, H05K 3/28

(54) **ELEKTRONISCHES LEISTUNGSMODUL MIT VON DECKEL ABGEDECKTER VERGUSSMASSE**

(71) Anmelder: Siemens Aktiengesellschaft, 80333 München (DE)
(72) Erfinder: Lorz, Roland, 91341 Röttenbach (DE); Werner, Ronny, 90429 Nürnberg (DE); Zeyß, Felix, 91052 Erlangen (DE)
(74) Vertreter: Siemens Patent Attorneys

(57) **Zusammenfassung**

Ein elektronisches Leistungsmodul (12) weist einen Schaltungsträger (13) auf, der eine Oberseite (14) und eine Unterseite (15) aufweist. Auf der Oberseite (14) des Schaltungsträgers (13) ist eine strukturierte Metallschicht (16) angeordnet, auf der Leistungshalbleiter (17) angeordnet sind, so dass die strukturierte Metallschicht (16) und die Leistungshalbleiter (17) Bestandteile einer elektronischen Leistungsschaltung bilden. Das Leistungsmodul (12) weist eine Wandstruktur (18) mit einer Innenseite (18a) auf, die zusammen mit der Oberseite (14) des Schaltungsträgers (13) einen Trog (19) bildet. Der Schaltungsträger (13) ist innerhalb des Troges (19) auf seiner Oberseite (14) mit einer weichen Vergussmasse (20) vergossen. Auf der Vergussmasse (20) ist ein Deckel (21) angeordnet, so dass der Deckel (21) vollflächig an der weichen Vergussmasse (20) anliegt. Ein äußerer Rand (22) des Deckels (21) ist konturgleich zu einem inneren Rand der Wandstruktur (18) ausgebildet.

## Beschreibung

Die vorliegende Erfindung geht aus von einem elektronischen Leistungsmodul,
- wobei das Leistungsmodul einen Schaltungsträger aufweist, der eine Oberseite und eine Unterseite aufweist,
- wobei auf der Oberseite des Schaltungsträgers eine strukturierte Metallschicht angeordnet ist und auf der strukturierten Metallschicht Leistungshalbleiter angeordnet sind, so dass die strukturierte Metallschicht und die Leistungshalbleiter Bestandteile einer elektronischen Leistungsschaltung bilden,
- wobei das Leistungsmodul eine Wandstruktur mit einer Innenseite aufweist, die zusammen mit der Oberseite des Schaltungsträgers einen Trog bildet,
- wobei der Schaltungsträger innerhalb des Troges auf seiner Oberseite mit einer weichen Vergussmasse vergossen ist.

Die vorliegende Erfindung geht weiterhin aus von einer Umrichtereinheit, die mindestens ein derartiges Leistungsmodul aufweist.

Leistungsmodule der vorstehend genannten Art und die zugehörigen Umrichtereinheiten sind allgemein bekannt.

Beim Betrieb derartiger elektronischer Leistungsmodule entsteht in den Leistungshalbleitern Wärme, die von den Leistungshalbleitern abgeführt werden muss. Aus diesem Grund ist üblicherweise an der Unterseite der Schaltungsträger ein Kühlkörper oder eine andere Wärmesenke angeordnet, der thermisch an den Schaltungsträger angekoppelt ist. Um die thermische Ankopplung zu optimieren, weist der Schaltungsträger üblicherweise an seiner Unterseite eine (unstrukturierte) Metallschicht auf. Gegebenenfalls kann weiterhin zwischen der Unterseite des Schaltungsträgers und dem Kühlkörper eine Wärmeleitpaste vorhanden sein.

Um den Übergangswiderstand vom Schaltungsträger zum Kühlkörper möglichst gering zu halten, sollte der Schaltungsträger möglichst großflächig und gleichmäßig an den Kühlkörper angedrückt werden. Besonders wichtig ist dieses Andrücken in denjenigen Bereichen, über denen sich die Leistungsschalter befinden.

Im Stand der Technik ist es bekannt, über Federelemente, Lastanschlüsse oder Druckstücke in der unmittelbaren Umgebung der Leistungshalbleiter Druck auf die Oberseite des Schaltungsträgers auszuüben und so die Unterseite des Schaltungsträgers an den Kühlkörper anzudrücken. Diese Vorgehensweise weist den Nachteil auf, dass die entsprechenden Bereiche der Oberseite des Schaltungsträgers für die Druckausübung freigehalten werden müssen oder zumindest zur Druckausübung geeignet sein müssen. Die Freiheit beim Design (Layout) der elektronischen Leistungsschaltung wird dadurch eingeschränkt.

In jüngerer Zeit ist es möglich geworden, den Druck direkt auf die Leistungshalbleiter aufzubringen. Diese Vorgehensweise setzt jedoch eine sogenannte planare Verbindungstechnik auf den Leistungshalbleitern voraus. Sie ist daher nicht stets anwendbar.

In der Regel ist der Schaltungsträger innerhalb des Troges auf seiner Oberseite mit einer Vergussmasse abgedeckt oder bedeckt. Die Vergussmasse ist in der Regel erforderlich, um eine ausreichend hohe Spannungsfestigkeit zu erzielen. Die Vergussmasse ist oftmals eine weiche Vergussmasse, die zunächst flüssig ist und dann durch Vernetzen zu einer elastischen, gummiartigen Masse wird. Eine derartige weiche Gussmasse hat auch im vernetzten Zustand noch eine sehr große Nachgiebigkeit und kann direkt keine Kräfte übertragen.

Es ist bereits realisiert worden, den Schaltungsträger innerhalb des Troges auf seiner Oberseite nicht mit einer weichen, sondern mit einer harten Vergussmasse bzw. einem sogenannten Mold zu vergießen. Ein derartiger Hartverguss ermöglicht es, Druck auf die Oberseite des Hartvergusses auszuüben und diesen Druck großflächig auf den Schaltungsträger zu übertragen. Alternativ ist es möglich, den Druck nicht direkt auf den Verguss selbst auszuüben, sondern den Druck auf den Trog (Gehäuse) auszuüben, der diesen dann auf die Vergussmasse überträgt. Die Vergussmasse überträgt den Druck wiederum auf den Schaltungsträger und drückt diesen an den Kühlkörper an. Die für die Bildung einer harten Vergussmasse verwendeten Materialien - meist Epoxidharze - sind jedoch im unverarbeiteten Zustand krebserregend. Ihre Handhabung ist daher problematisch.

Die Aufgabe der vorliegenden Erfindung besteht darin, Möglichkeiten zu schaffen, mittels derer trotz Verwendung einer weichen Vergussmasse auf einfache Art und Weise großflächig und insbesondere auch im Bereich der Leistungshalbleiter Druck auf die Oberseite des Schaltungsträgers ausgeübt werden kann.

Die Aufgabe wird durch ein elektronisches Leistungsmodul mit den Merkmalen des Anspruchs 1 gelöst. Vorteilhafte Ausgestaltungen des Leistungsmoduls sind Gegenstand der abhängigen Ansprüche 2 bis 9.

Erfindungsgemäß wird ein elektronisches Leistungsmodul der eingangs genannten Art dadurch ausgestaltet, dass auf der Vergussmasse ein Deckel angeordnet ist, so dass der Deckel vollflächig an der weichen Vergussmasse anliegt, und dass ein äußerer Rand des Deckels konturgleich zu einem inneren Rand der Wandstruktur ausgebildet ist.

Der Schaltungsträger ist üblicherweise als Substrat ausgebildet. Der Schaltungsträger einschließlich der auf dem Schaltungsträger befindlichen Metallschicht kann insbesondere als DCB-Substrat oder als AMB-Substrat oder als IMS-Substrat ausgebildet sein. Die Abkürzungen DCB, AMB und IMS stehen, wie Fachleuten allgemein bekannt ist, für "direct copper bonding", "active metal bracing" und "insulated metal substrate". Das Metall, aus dem die Metallschicht besteht, kann insbesondere Kupfer sein.

Die strukturierte Metallschicht und die Leistungshalbleiter realisieren als Bestandteile einer elektronischen Leistungsschaltung in der Regel eine Anzahl von Halbbrücken einer Umrichterschaltung, meist entweder eine einzelne Halbbrücke oder drei Halbbrücken. Eine Halbbrücke besteht aus (mindestens) zwei in Serie geschalteten Halbleiterschaltern, denen - intrinsisch oder als eigenständiges Bauelement - jeweils eine Diode parallel geschaltet ist. Die beiden Enden der Halbbrücke können jeweils mit einem Anschluss für ein hohes und ein niedriges Gleichspannungspotenzial verbunden werden, ein Knotenpunkt zwischen den beiden Halbleiterschaltern mit einem Anschluss für ein Wechselspannungspotenzial. Im Falle der Bildung von mehreren Halbbrücken sind die beiden Gleichspannungspotenziale in der Regel einheitlich für die Halbbrücken, die Wechselspannungspotenziale individuell für die jeweilige Halbbrücke.

Die Wandstruktur enthält üblicherweise elektrische Kontaktelemente, welche einzeln oder in Gruppen zu mehreren jeweils einen der Anschlüsse für das hohe und das niedrige Gleichspannungspotenzial und das Wechselspannungspotenzial bzw. die Wechselspannungspotenziale und weiterhin Anschlüsse für ein Steuersignal bzw. für Steuersignale bilden. Die Kontaktelemente ragen meist an der von dem Schaltungsträger abgewandten Oberseite der Wandstruktur über die Wandstruktur hinaus. Diese Sachverhalte sind im Rahmen der vorliegenden Erfindung jedoch von untergeordneter Bedeutung. Im Rahmen der vorliegenden Erfindung kommt es lediglich auf die Trogbildung an.

Weiche Vergussmassen sind Fachleuten allgemein bekannt. Üblicherweise handelt es sich um Massen auf Silikonbasis. Sie weisen dauerelastische Eigenschaften auf.

Der Begriff "konturgleich" soll bedeuten, dass die Kontur des Deckels gleichartig zum Verlauf des inneren Randes der Wandstruktur ist. Der Deckel kann zwar einen geringen Abstand von dem inneren Rand aufweisen, der Rand des Deckels verläuft jedoch stets entlang des inneren Randes der Wandstruktur. Die Kontur des Deckels kann also nicht nur identisch mit der Kontur des inneren Randes sein, sondern umfasst auch eine Kontur, die sozusagen durch eine zentrische Streckung der Kontur des inneren Randes mit einem Faktor geringfügig kleiner als 1 gebildet wird, also sozusagen ausgehend von der Kontur des inneren Randes ein bisschen geschrumpft ist.

In vielen Fällen bildet der Deckel eine Fläche, die kleiner als der von der Wandstruktur umschlossene Querschnitt ist. In diesem Fall bildet der Deckel, wenn er auf der Vergussmasse angeordnet ist, mit der Wandstruktur einen Spalt. Diese Ausgestaltung ermöglicht es insbesondere, den Deckel ohne größere Kraftausübung nachträglich auf die Vergussmasse aufzusetzen.

Wenn der Deckel eine Fläche aufweist, die kleiner als der von der Wandstruktur umschlossene Querschnitt ist, ist es erforderlich, zuverlässig ein Kriechen der weichen Vergussmasse durch den Spalt hindurch zu verhindern. Hierfür sind im Kern zwei Ausgestaltungen möglich, die gegebenenfalls auch miteinander kombiniert sein können.

Zum einen ist es möglich, dass der Spalt eine Breite von maximal 0,3 mm aufweist, meist von maximal 0,2 mm, insbesondere von maximal 0,1 mm. Bei einem derart kleinen Spalt kann es ausreichen, den kleinen Spalt völlig frei zu lassen. Zum anderen ist es möglich, dass der Spalt durch eine Zusatzstruktur verschlossen ist. Die Zusatzstruktur wirkt als Dichtung. Durch sie wird der Spalt - unabhängig von seiner genauen Breite - abgedichtet. Wie bereits erwähnt, können diese beiden Ausgestaltungen miteinander kombiniert sein.

Die Ausgestaltung der Zusatzstruktur kann nach Bedarf sein, sofern sie den gewünschten Zweck bewirkt, also die Abdichtung des Spaltes und damit das Verhindern des Kriechens der weichen Vergussmasse durch den Spalt hindurch.

Beispielsweise ist es möglich, dass die Zusatzstruktur als am äußeren Rand des Deckels angeordnete umlaufende Dichtung ausgebildet ist. Der Deckel weist in diesem Fall also an seinem äußeren Rand eine umlaufende Dichtung auf. Die Dichtung kann als eigenständiges Element ausgebildet sein. Sie kann auch an den Deckel angespritzt oder an den Deckel angeschäumt sein. Es kann sich auch um eine Verjüngung im Material des Deckels handeln, so dass diese Verjüngung eine Dichtlippe bildet.

Alternativ ist es möglich, dass die Zusatzstruktur als an einer der Vergussmasse zugewandten Unterseite des Deckels angeordnete und über den äußeren Rand des Deckels überstehende Dichtungsmatte ausgebildet ist. In diesem Fall weist also der Deckel an seiner der Vergussmasse zugewandten Unterseite eine Dichtungsmatte auf.

Wiederum alternativ ist es möglich, dass die Zusatzstruktur als am äußeren Rand des Deckels umlaufende Verbindungsstruktur ausgebildet ist, über die der Deckel mit der Wandstruktur verbunden ist. In diesem Fall ist also der Deckel über die Verbindungsstruktur mit der Wandstruktur verbunden. Die Verbindungsstruktur kann in diesem Fall insbesondere eine Schweißnaht sein oder aus Klebstoff bestehen.

Wiederum alternativ ist es möglich, dass die Zusatzstruktur als am äußeren Rand des Deckels umlaufende Verbindungsstruktur ausgebildet ist, über die der Deckel mit der Vergussmasse verbunden ist. In diesem Fall ist also der Deckel über die Verbindungsstruktur nicht mit der Wandstruktur, sondern mit der Vergussmasse verbunden. Die Verbindungsstruktur kann in diesem Fall insbesondere aus Klebstoff bestehen.

Alternativ ist es möglich, dass die Wandstruktur an ihrer Innenseite eine umlaufende Nut aufweist und der Deckel in die Nut eingerastet ist. In diesem Fall bildet der Deckel eine Fläche, die nicht kleiner, sondern genau genommen sogar geringfügig größer als der von der Wandstruktur umschlossene Querschnitt ist. Durch das Einrasten des Deckels in die Nut wird zum einen der Deckel zuverlässig gehalten.Weiterhin wird durch die Labyrinthwirkung der Nut das Kriechen der Vergussmasse durch die Nut hindurch verhindert.

Die Aufgabe wird weiterhin durch eine Umrichtereinheit gelöst, die mindestens ein erfindungsgemäßes Leistungsmodul aufweist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein Blockschaltbild,
- FIG 2: eine Umrichtertopologie,
- FIG 3: ein Leistungsmodul im Schnitt,
- FIG 4: ein Leistungsmodul und einen Deckel von oben und
- FIG 5 bis 9: Möglichkeiten zur Anordnung eines Deckels auf einer Vergussmasse.

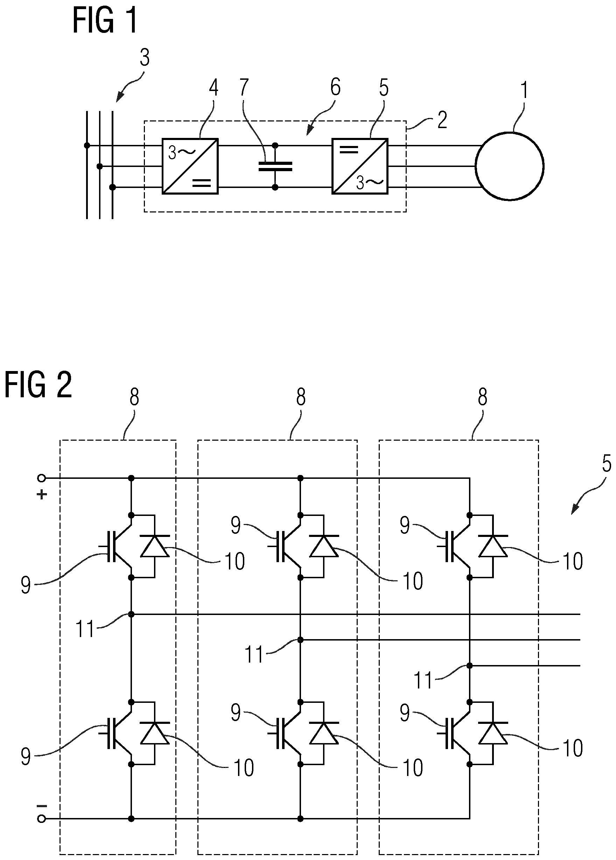

Gemäß FIG 1 soll eine Last 1 über eine Umrichtereinheit 2 aus einer Energiequelle 3 - dargestellt ist in FIG 1 als Energiequelle 3 ein mehrphasiges Versorgungsnetz - mit elektrischer Energie versorgt werden. Die Umrichtereinheit 2 umfasst einen Gleichrichter 4, einen Wechselrichter 5 und dazwischen einen Gleichspannungszwischenkreis 6, in der Regel mit einem Zwischenkreiskondensator 7. Die Umrichtereinheit 2 könnte aber auch anders ausgebildet sein, beispielsweise ohne Gleichrichter 4, falls die Energiequelle eine Gleichstromquelle ist, oder als Direktumrichter.

FIG 2 zeigt einen typischen Aufbau des Wechselrichters 5. Gemäß FIG 2 umfasst der Wechselrichter 5 mehrere Halbbrücken 8, die jeweils mindestens zwei in Reihe geschaltete Halbleiterschalter 9 aufweisen. Die Halbleiterschalter 9 können beispielsweise IGBTs oder Feldeffekttransistoren sein, insbesondere MOSFETs. Den Halbleiterschaltern 9 ist jeweils eine Diode 10 parallelgeschaltet. Die Dioden 10 können nach Bedarf eigenständige Bauelemente oder intrinsische Bestandteile der Halbleiterschaltern 9 sein. Zwischen den beiden Halbleiterschaltern 9 einer jeweiligen Halbbrücke 8 befindet sich ein Knotenpunkt 11. An dem jeweiligen Knotenpunkt 11 kann ein jeweiliges Wechselspannungspotenzial abgegriffen werden, das der Last 1 zugeführt werden kann. An den Enden der jeweiligen Halbbrücke 8 können ein hohes und ein niedriges Gleichspannungspotenzial - angedeutet durch ein Pluszeichen und ein Minuszeichen - an die Halbbrücken 8 angelegt werden.

Der Gleichrichter 4 kann auf die gleiche Art und Weise oder anders aufgebaut sein. Insbesondere kann der Gleichrichter 4 alternativ zu einigen oder allen der Halbleiterschalter Dioden aufweisen, im einfachsten Fall also ausschließlich aus Dioden bestehen.

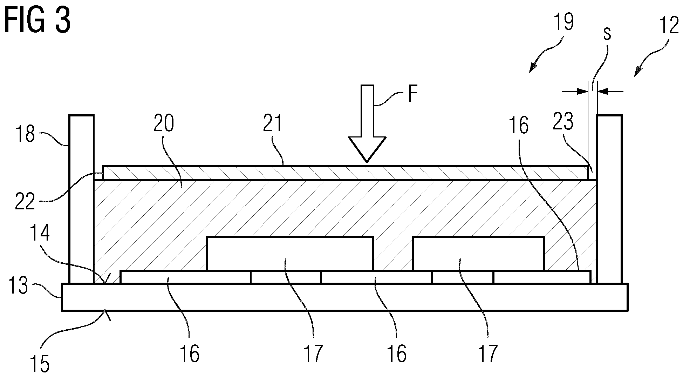

Ein elektronisches Leistungsmodul 12 - dargestellt in FIG 3 - weist einen Schaltungsträger 13 auf, der seinerseits eine Oberseite 14 und eine Unterseite 15 aufweist. Auf der Oberseite 14 des Schaltungsträgers 13 ist eine strukturierte Metallschicht 16 angeordnet. Auf der strukturierten Metallschicht 16 sind Leistungshalbleiter 17 angeordnet, so dass die strukturierte Metallschicht 16 und die Leistungshalbleiter 17 Bestandteile einer elektronischen Leistungsschaltung bilden. Über oberhalb der Leistungshalbleiter 17 angeordnete elektrische Verbindungselemente (Bonddrähte, nicht dargestellt) wird der verbleibende Teil der elektrischen Leistungsschaltung realisiert. Die gebildete Leistungsschaltung korrespondiert in aller Regel mit einer der Halbbrücken 8 von FIG 2 oder mit allen drei Halbbrücken 8 des Wechselrichters 5 von FIG 2. Sie kann auch mit Halbbrücken des Gleichrichters 4 korrespondieren. Die Leistungshalbleiter 17 korrespondieren vorliegend also mit einem der Halbleiterschalter 9 oder Dioden 10 des Wechselrichters 5 oder Halbleiterschaltern oder Dioden des Gleichrichters 4. Weiterhin umfasst die Umrichtereinheit 2 somit mindestens ein derartiges elektronisches Leistungsmodul 12.

Das Leistungsmodul 12 weist weiterhin eine Wandstruktur 18 auf. Die Wandstruktur 18 umgibt den Schaltungsträger 13 an der Oberseite 14. Die Wandstruktur 18 kann nach Bedarf auf die Oberseite 14 des Schaltungsträgers 13 aufgesetzt sein oder die Oberseite 14 radial außen umgeben. In jedem Fall bilden die Wandstruktur 18 und die Oberseite des Schaltungsträgers 13 zusammen einen Trog 19, der von einer Innenseite 18a der Wandstruktur 18 und der Oberseite 14 des Schaltungsträgers 13 begrenzt wird.

Innerhalb des Troges 19 ist der Schaltungsträger 13 auf seiner Oberseite 14 mit einer Vergussmasse 20 vergossen. Die Vergussmasse 20 ist eine weiche Vergussmasse, in der Regel auf Silikonbasis. Sie weist dauerelastische, gummiartige Eigenschaften auf.

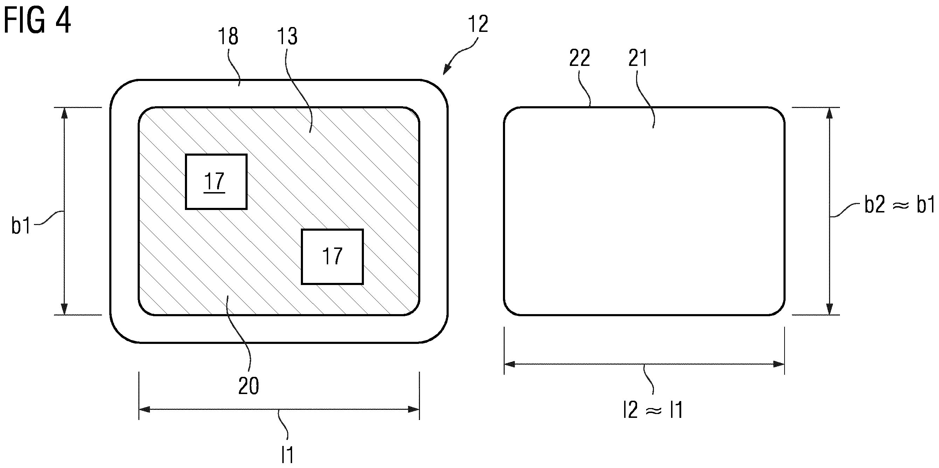

Auf der Vergussmasse 20 ist ein Deckel 21 angeordnet. Der Deckel 21 kann insbesondere auf die Vergussmasse 20 aufgesetzt sein. Der Deckel 21 liegt vollflächig an der weichen Vergussmasse 20 an. Ein äußerer Rand 22 des Deckels 21 ist gemäß FIG 4 konturgleich zu einem inneren Rand der Wandstruktur 18 ausgebildet. Wenn also der Trog 19 entsprechend der Darstellung in FIG 4 im wesentlichen als Rechteck mit einer Länge 11, einer Breite b1 und abgerundeten Ecken ausgebildet ist, so ist der Deckel 21 ebenso im wesentlichen als Rechteck mit einer Länge l2, einer Breite b2 und abgerundeten Ecken ausgebildet ist, wobei die Längen l1 und l2 sowie die Breiten b1 und b2 und auch die Abrundung der Ecken zumindest im wesentlichen übereinstimmen.

In vielen Fällen wird es so sein, dass der Deckel 21 eine Fläche bildet, die kleiner als der von der Wandstruktur 18 umschlossene Querschnitt ist. In diesem Fall bildet der Deckel 21, wenn er auf der Vergussmasse 20 angeordnet ist, gemäß FIG 3 mit der Wandstruktur 18 einen Spalt 23 mit einer Spaltbreite s. Auch in diesem Fall sind verschiedene Ausgestaltungen möglich.

Zum einen besteht entsprechend der Darstellung in FIG 3 die Möglichkeit, dass die Spaltbreite s bei maximal 0,3 mm liegt. Bei einem derart kleinen Spalt 23 kann auch dann, wenn auf den Deckel 21 eine große Druckkraft F ausgeübt wird, der Druck über die Vergussmasse 20 auf den Schaltungsträger 13, die strukturierte Metallschicht 16 und die Leistungshalbleiter 17 übertragen werden, ohne dass die Vergussmasse 20 im Laufe der Zeit durch den - offen bleibenden - Spalt 23 austreten kann. In diesem Fall ist es möglich, den Deckel 21 erst nach dem Vernetzen der Vergussmasse 20 auf die Vergussmasse 20 aufzusetzen. Vorzugsweise wird die Spaltbreite s so klein wie möglich gewählt, also sogar unter dem Wert von 0,3 mm, beispielsweise bei maximal 0,2 mm und insbesondere bei maximal 0,1 mm.

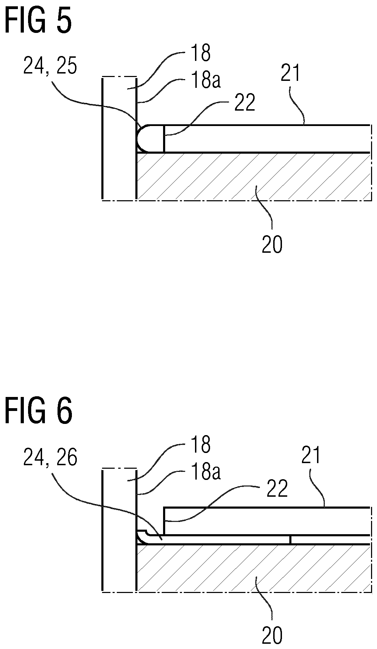

Zum anderen besteht die Möglichkeit, dass der Spalt 23 durch eine Zusatzstruktur 24 verschlossen ist. In diesem Fall kann - nicht aber muss - der Spalt 23 auch eine Spaltbreite s von mehr als 0,3 mm aufweisen. Mögliche Ausgestaltungen der Zusatzstruktur 24 sind in den FIG 5 bis 8 dargestellt.

Beispielsweise ist es entsprechend der Darstellung in FIG 5 möglich, dass die Zusatzstruktur 24 als Dichtung 25 ausgebildet ist, die am äußeren Rand 22 des Deckels 21 angeordnet ist und entlang des äußeren Randes 22 umläuft. Auch in diesem Fall ist es möglich, den Deckel 21 erst nach dem Vernetzen der Vergussmasse 20 auf die Vergussmasse 20 aufzusetzen.

Alternativ ist es entsprechend der Darstellung in FIG 6 möglich, dass die Zusatzstruktur 24 als Dichtungsmatte 26 ausgebildet ist, die an der Unterseite des Deckels 21 angeordnet ist und über den Rand 22 des Deckels 21 übersteht. Diesen Fall sollte die Dichtungsmatte 26 mindestens bis zur Innenseite 18a der Wandstruktur 18 überstehen, gegebenenfalls sogar noch etwas darüber hinaus. Der Überstand ist möglich, weil die Dichtungsmatte 26 flexibel genug ist, so dass sie beim Aufsetzen des Deckels 21 nach oben gebogen werden kann. Die Unterseite des Deckels 21 ist diejenige Seite des Deckels 21, die der Vergussmasse 20 zugewandt ist. Auch in diesem Fall ist es möglich, den Deckel 21 erst nach dem Vernetzen der Vergussmasse 20 auf die Vergussmasse 20 aufzusetzen. Die Dichtungsmatte 26 kann nach Bedarf vollflächig sein oder entsprechend der Darstellung in FIG 6 als relativ breiter Streifen ausgebildet sein, der entlang des Randes 22 des Deckels 21 umläuft.

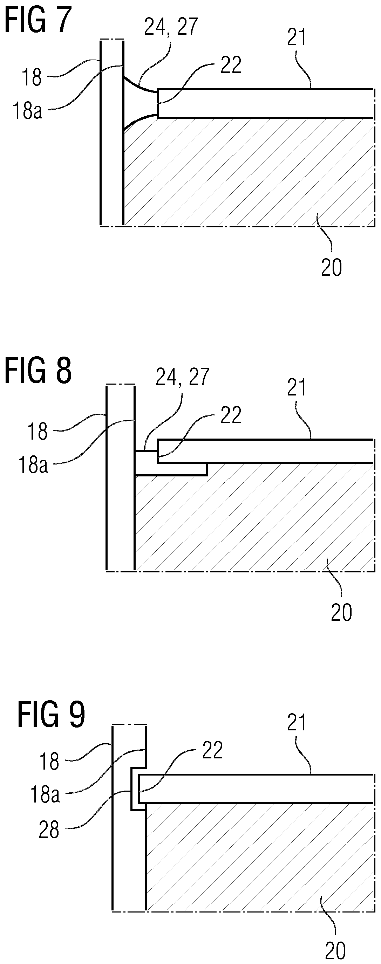

Eine weitere Möglichkeit besteht darin, die Zusatzstruktur 24 als Verbindungsstruktur 27 auszubilden, die am äußeren Rand 22 des Deckels 21 umläuft. In diesem Fall kann der Deckel 21 über die Verbindungsstruktur 27 entweder gemäß FIG 7 mit der Wandstruktur 18 oder gemäß FIG 8 mit der Vergussmasse 20 verbunden sein. Im Falle der Ausgestaltung von FIG 7 wird der Deckel 21 direkt nach dem Vergießen der Vergussmasse 20 oder etwas später, in aller Regel aber vor dem vollständigen Vernetzen der Vergussmasse 20, auf die Vergussmasse 20 aufgesetzt. Der Deckel 21 kann über die Verbindungsstruktur 27 mit der Wandstruktur 18 beispielsweise geschweißt oder geklebt sein. Im Falle einer Schweissung kommt insbesondere eine Laserschweissung in Frage. Im Falle der Ausgestaltung von FIG 8 wird der Deckel 21 in aller Regel erst nach dem vollständigen Vernetzen der Vergussmasse 20 auf die Vergussmasse 20 aufgesetzt. Beispielsweise kann als Verbindungsstruktur 27 zunächst auf die (bereits vernetzte) Vergussmasse 20 eine sogenannte Kleberaupe aufgebracht werden und sodann der Deckel 21 aufgesetzt werden.

FIG 9 zeigt eine weitere Möglichkeit zur Abdichtung des Deckels 21 gegenüber der Wandstruktur 18. Gemäß FIG 9 weist die Wandstruktur 18 an ihrer Innenseite 8a eine Nut 28 auf. Die Nut 28 ist umlaufend. Bei der Ausgestaltung von FIG 9 ist der Deckel 21 in die Nut 28 eingerastet. Der Rand 22 des Deckels 21 befindet sich also in der Nut 28.

Alternativ zu einem nachträglichen Aufsetzen des Deckels 21 auf die Vergussmasse 20 kann es sogar möglich sein, den Deckel 21 vor dem Vergießen der Vergussmasse 20 auf den Trog 19 aufzusetzen. In diesem Fall muss der Deckel 21 fixiert werden, beispielsweise durch Kleben. Weiterhin muss eine Öffnung verbleiben, durch die hindurch die Vergussmasse 20 in den Bereich unterhalb des Deckels 21 gegossen werden kann. Die Vergussmasse 20 muss in diesem Fall hinreichend dünnflüssig sein. Weiterhin muss die Öffnung nachträglich verschlossen werden.

Die vorliegende Erfindung weist viele Vorteile auf. Insbesondere ist es trotz der Verwendung einer üblichen "problemlosen" weichen Vergussmasse 20 möglich, ausgehend vom Deckel 21 über die Vergussmasse 20 Druck auf den Schaltungsträger 13 und die auf dem Schaltungsträger 13 angeordneten Elemente (strukturierte Metallschicht 16, Leistungshalbleiter 17) auszuüben. Dies gilt auch dann, wenn der Deckel 21 - beispielsweise im Falle der Ausgestaltungen der FIG 7 und 9 - bezüglich der Wandstruktur 18 fixiert ist. Denn auch dann kann auf den mittleren Bereich des Deckels 21 noch die Druckkraft F ausgeübt werden, die sich als quasi hydrostatischer Druck auf die gesamte Vergussmasse 20 überträgt. Die Druckkraft F wirkt nicht nur neben den Leistungshalbleitern 17, sondern direkt auch auf die Leistungshalbleiter 17. Das bewirkt einen guten Kontakt und damit einen niedrigen Wärmeübergangswiderstand. Es kann weiterhin eine konventionelle weiche Vergussmasse 20 verwendet werden. Die elektrische Verbindung der Leistungshalbleiter 17 ist weiterhin über übliche Bonddrähte möglich. Die Freiheit für das Schaltungslayout wird bei dem erfindungsgemäßen Leistungsmodul 12 nicht beschränkt. Der genaue Ort, an dem die Druckkraft F auf den Deckel 21 ausgeübt wird, ist irrelevant, weil der Druck sich auf die Vergussmasse 20 gleichmäßig verteilt. Die Möglichkeit, den Kontakt zum Kühlkörper dadurch zu verbessern, dass man den Schaltungsträger 13 mit einer Vorbiegung versieht, bleibt erhalten.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronisches Leistungsmodul,
- wobei das Leistungsmodul einen Schaltungsträger (13) aufweist, der eine Oberseite (14) und eine Unterseite (15) aufweist,
- wobei auf der Oberseite (14) des Schaltungsträgers (13) eine strukturierte Metallschicht (16) angeordnet ist und auf der strukturierten Metallschicht (16) Leistungshalbleiter (17) angeordnet sind, so dass die strukturierte Metallschicht (16) und die Leistungshalbleiter (17) Bestandteile einer elektronischen Leistungsschaltung bilden,
- wobei das Leistungsmodul eine Wandstruktur (18) mit einer Innenseite (18a) aufweist, die zusammen mit der Oberseite (14) des Schaltungsträgers (13) einen Trog (19) bildet,
- wobei der Schaltungsträger (13) innerhalb des Troges (19) auf seiner Oberseite (14) mit einer weichen Vergussmasse (20) vergossen ist,
**dadurch gekennzeichnet,**
**dass** auf der Vergussmasse (20) ein Deckel (21) angeordnet ist, so dass der Deckel (21) vollflächig an der weichen Vergussmasse (20) anliegt, und dass ein äußerer Rand (22) des Deckels (21) konturgleich zu einem inneren Rand der Wandstruktur (18) ausgebildet ist.

2. Leistungsmodul nach Anspruch 1,
**dadurch gekennzeichnet,**
**dass** der Deckel (21) eine Fläche bildet, die kleiner als der von der Wandstruktur (18) umschlossene Querschnitt ist, so dass der Deckel (21), wenn er auf der Vergussmasse (20) angeordnet ist, mit der Wandstruktur (18) einen Spalt (23) bildet.

3. Leistungsmodul nach Anspruch 2,
**dadurch gekennzeichnet,**
**dass** der Spalt (23) eine Breite (s) von maximal 0,3 mm aufweist, vorzugsweise von maximal 0,2 mm, insbesondere von maximal 0,1 mm.

4. Leistungsmodul nach Anspruch 2 oder 3,
**dadurch gekennzeichnet,**
**dass** der Spalt (23) durch eine Zusatzstruktur (24) verschlossen ist.

5. Leistungsmodul nach Anspruch 4,
**dadurch gekennzeichnet,**
**dass** die Zusatzstruktur (24) als am äußeren Rand (22) des Deckels (21) angeordnete umlaufende Dichtung (25) ausgebildet ist.

6. Leistungsmodul nach Anspruch 4,
**dadurch gekennzeichnet,**
**dass** die Zusatzstruktur (24) als an einer der Vergussmasse (20) zugewandten Unterseite des Deckels (21) angeordnete und über den äußeren Rand (22) des Deckels (21) überstehende Dichtungsmatte (26) ausgebildet ist.

7. Leistungsmodul nach Anspruch 4,
**dadurch gekennzeichnet,**
**dass** die Zusatzstruktur (24) als am äußeren Rand (22) des Deckels (21) umlaufende Verbindungsstruktur (27) ausgebildet ist, über die der Deckel (21) mit der Wandstruktur (18) verbunden ist.

8. Leistungsmodul nach Anspruch 4,
**dadurch gekennzeichnet,**
**dass** die Zusatzstruktur (24) als am äußeren Rand (22) des Deckels (21) umlaufende Verbindungsstruktur (27) ausgebildet ist, über die der Deckel (21) mit der Vergussmasse (20) verbunden ist.

9. Leistungsmodul nach Anspruch 1,
**dadurch gekennzeichnet,**
**dass** die Wandstruktur (18) an ihrer Innenseite (18a) eine umlaufende Nut (28) aufweist und dass der Deckel (21) in die Nut (28) eingerastet ist.

10. Umrichtereinheit, wobei die Umrichtereinheit mindestens ein Leistungsmodul (12) nach einem der obigen Ansprüche aufweist.
